# EUROPEAN PATENT APPLICATION

(11) **EP 1 699 132 A1**
(43) Date of publication of application: **06.09.2006**
(21) Application number: 06003844.5
(22) Date of filing: 24.02.2006
(51) Int. Cl.: H03B 5/12

(54) **Voltage controlled oscillator**

(30) Priority: 01.03.2005 JP 2005055912
(71) Applicant: NEC Electronics Corporation, Kawasaki, Kanagawa 211-8668 (JP)
(72) Inventor: Shibata, Tooru c/o NEC Electronics Corporation, Kawasaki Kanagawa 211-8668 (JP)
(74) Representative: Glawe, Delfs, Moll

(57) **Abstract**

A voltage controlled oscillator includes an LC resonance circuit having an inductance and a voltage dependent variable capacitance connected in parallel between first and second output terminals; a transistor pair circuit connected in parallel with the LC resonance circuit between the first and second output terminals and having negative conductance to keep oscillation of the LC resonance circuit; a resistance having one end connected with the oscillation transistor pair circuit; and a current source connected with the other end of the resistance.

## Description

### Background of the Invention

### 1. Field of the Invention

The present invention relates to a voltage controlled oscillator.

### 2. Description of the Related Art

A voltage controlled oscillator is generally used in a PLL (Phase Locked Loop) circuit to generate a clock signal to be sent to a CPU and a chipset. Thus, the voltage controlled oscillator is required to output a more stable oscillation signal. One important characteristic of the voltage controlled oscillator is a phase-noise characteristic. The phase-noise characteristic directly affects a jitter characteristic, and a lower phase-noise characteristic is required in improvement of communication speed.

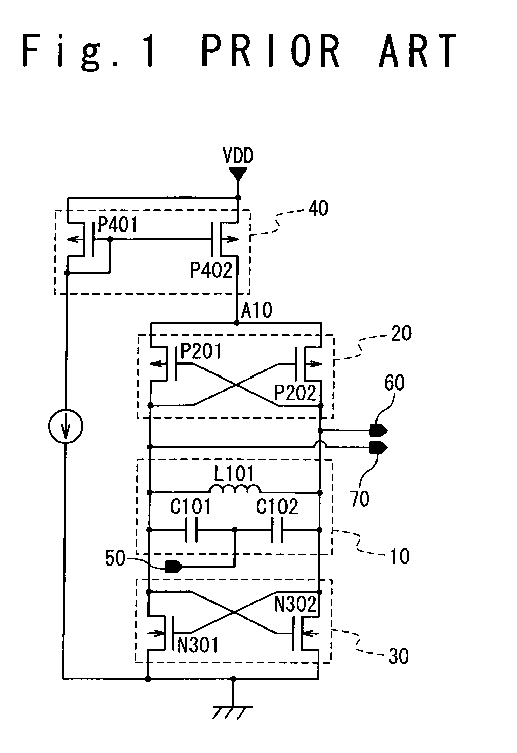

Fig. 1 is a circuit diagram showing a configuration of a voltage controlled oscillator as a first conventional example. The voltage controlled oscillator of the first conventional example has an LC resonant circuit 10; a P-channel cross-coupled transistor pair 20 and an N-channel cross-coupled transistor pair 30 and a current source 40. The P-channel cross-coupled transistor pair 20 and the N-channel cross-coupled transistor pair 30 are connected in parallel to the LC resonant circuit 10 through output terminals 60 and 70. The current source 40 is connected to the P-channel cross-coupled transistor pair 20 through a node A10. The LC resonant circuit 10 is provided with an inductor L101, and variable capacitors C101 and C102 which are connected in series through a control voltage terminal 50 to form a variable capacitance. The inductor L101 and the variable capacitance are connected in parallel, where one connection node is connected to the output terminal 60 while the other connection node is connected to the output terminal 70. The P-channel cross-coupled transistor pair 20 has P-channel transistors P201 and P202, the sources of which are connected to the node A10. The gate and drain of the P-channel transistor P201 are connected to the output terminals 60 and 70, respectively. The gate and drain of the P-channel transistor P202 are connected to the output terminals 70 and 60, respectively. The N-channel cross-coupled transistor pair 30 has N-channel transistors N301 and N302, the sources of which are grounded. The gate and drain of the N-channel transistor N301 are connected to the output terminals 60 and 70, respectively. The gate and drain of the N-channel transistor N302 are connected to the output terminals 70 and 60, respectively. The current source 40 is a current mirror circuit having P-channel transistors P401 and P402, gates of which are connected to each other, and sources of which are connected in common to a power source voltage VDD. The drain and gate of the P-channel transistor P401 are connected to a constant current source as an input of the current mirror circuit, and the drain of the P-channel transistor P402 is connected to the node A10.

The LC resonant circuit 10 with the above configuration oscillates at a frequency (a resonance frequency fo) at which impedance is maximized, and oscillation output signals OUT 10 and OUT 20 of the resonance frequency fo are outputted as a differential signal from the output terminals 60 and 70, respectively. At this time, the P-channel cross-coupled transistor pair 20 and the N-channel cross-coupled transistor pair 30 operate as negative conductance in such a manner that the oscillation output signals can be outputted without attenuation. Also, a capacitance value of the variable capacitance in the LC resonant circuit 10 changes in accordance with a control voltage supplied from the control voltage input terminal 50. That is to say, the voltage controlled oscillator operates as an oscillator in which the resonance frequency fo changes in accordance with the control voltage.

Next, a voltage controlled oscillator of the second conventional example is disclosed in Japanese Laid Open Patent Application (JP-P2003-324315A). In the voltage controlled oscillator of the second conventional example, an LC parallel resonant circuit is connected between a common source of N-channel cross-coupled transistors having negative conductance, and a current source, and the common source is grounded through an LC series resonant circuit that uses a parasitic inductor. Thus, a phase-noise characteristic is improved. In this voltage controlled oscillator of the second conventional example, by setting resonance frequencies of the LC parallel resonant circuit and LC series resonant circuit to appropriate value, it is prevented that even harmonics associated with an oscillation operation are superimposed on a circuit current. For example, by setting the resonance frequency to a double of an oscillation frequency of the voltage controlled oscillator, a second harmonic is not superimposed on the circuit current, thereby preventing deterioration of the phase-noise characteristic.

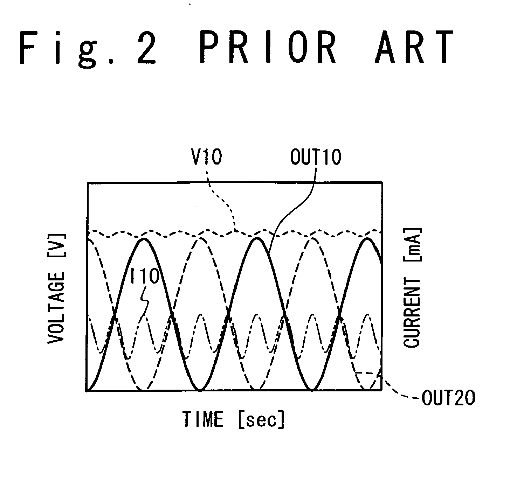

Fig. 2 is a diagram showing the oscillation output signals OUT 10 and OUT 20, voltage at the node A10, and a circuit current I10 outputted from the current source 40 in the voltage controlled oscillator of the first conventional example. As shown in Fig. 2, the even harmonics of the oscillation frequency of the oscillation output signals OUT 10 and OUT 20, e.g., fourth harmonics in this case are superimposed between the source and drain of the P-channel transistor P402 of the current source 40, with the oscillation operation of the LC resonant circuit 10 of the first conventional example. For this reason, a voltage V10 at the node A10 cannot be stabilized, so that the circuit current I10 oscillates with large amplitude, resulting in degradation of the phase-noise characteristic in the oscillation output signals OUT 10 and OUT 20.

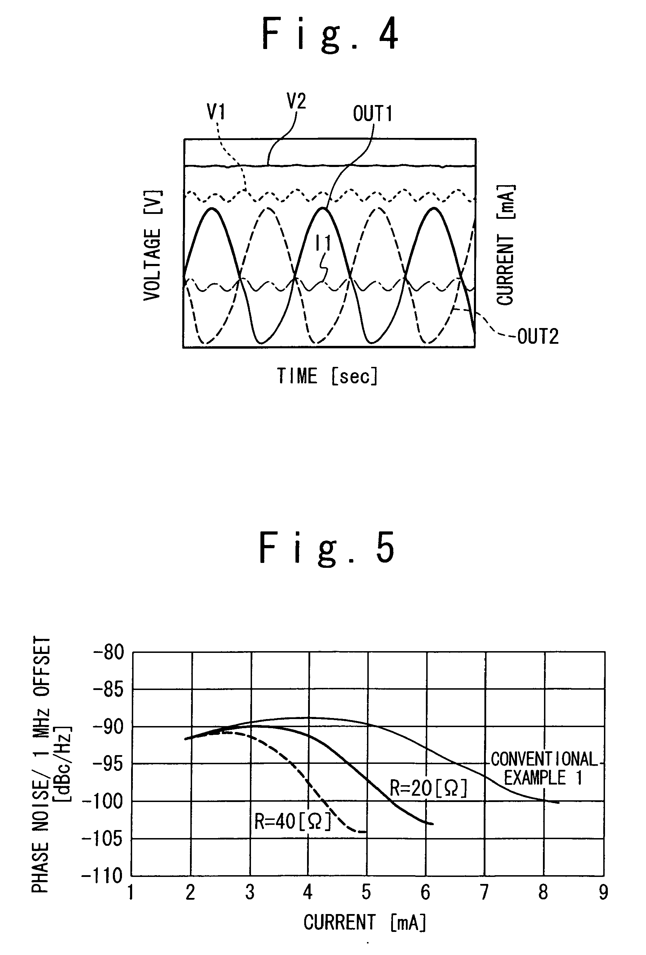

As a way to reduce phase-noise caused by harmonics, it may be possible to increase the circuit current I10 so as to increase the power of the oscillation output signals OUT 10 and OUT 20. Simulating the relationship between current consumption and phase-noise (offset frequency of 1 MHz) with reference to Fig. 5, the current consumption must be 8 [mA] or above, to reduce the phase-noise to
- 100 [dBc/Hz] or below. Furthermore, the current consumption must be 9 to 10 [mA] or so, considering manufacturing variations and so on. In this case, power consumption in the voltage controlled oscillator is increased.

The inductor used in the LC parallel resonant circuit or the LC series resonant circuit included in the voltage controlled oscillator of the second conventional example generally requires a large chip area. For this reason, a circuit area of the oscillator itself is increased. Also, the deterioration of the phase-noise characteristic is caused, when the resonance frequency is off from the oscillation frequency multiplied by even numbers due to manufacturing variations.

### Summary of the Invention

An object of the present invention is to provide a voltage controlled oscillator, which can output an oscillation signal in which a phase-noise is reduced.

Another object of the present invention is to provide a voltage controlled oscillator, in which power consumption is low.

Still object of the present invention is to provide a voltage controlled oscillator, which has a small circuit area.

In an aspect of the present invention, a voltage controlled oscillator includes an LC resonance circuit having an inductance and a voltage dependent variable capacitance connected in parallel between first and second output terminals; a transistor pair circuit connected in parallel with the LC resonance circuit between the first and second output terminals and having negative conductance to keep oscillation of the LC resonance circuit; a resistance having one end connected with the oscillation transistor pair circuit; and a current source connected with the other end of the resistance.

Here, the transistor pair circuit may include a first transistor and a second transistor. The gate terminal of the first transistor is connected with the first output terminal to output a first oscillation output signal, and the gate terminal of the second transistor is connected with the second output terminal to output a second oscillation output signal. Also, one terminal of each of the first and second transistors is connected with the current source transistor through the resistance, and the other terminal of the first transistor is connected with the second output terminal and the other terminal of the second transistor is connected with the first output terminal.

Also, the inductance may include two inductors connected in series. A node between the two inductors may be connected to a power supply voltage, and the current source may be connected to a ground voltage.

Also, the current source may include a current source transistor, and the first and second transistors and the current source transistor may be of a same conductive type.

Also, the voltage controlled oscillator may further include another transistor pair circuit connected in parallel with the LC resonance circuit between the first and second output terminals on an opposite side to the transistor pair circuit with respect of the LC resonance circuit and having negative conductance to keep oscillation of the LC resonance circuit. In this case, the other transistor pair circuit may include third and fourth transistors. The gate terminal of the third transistor may be connected with the first output terminal, and the gate terminal of the fourth transistor may be connected with the second output terminal. One terminal of each of the third and fourth transistors may be a first voltage. The other terminal of the third oscillation transistor may be connected with the second output terminal and the other terminal of the fourth oscillation transistor may be connected with the first output terminal. The current source may be connected with a second voltage.

Also, one of the first voltage and the second voltage may be a power source voltage and the other is a ground voltage.

Also, the current source may include a current source transistor. The first and second transistors and the current source transistor may be of a same conductive type, and the conductive type of the first and second transistors may be different from that of the third and fourth transistors.

Also, the current source may be a current mirror circuit including a current source transistor.

Also, the voltage controlled oscillator may further include a capacitance connected to a node between the current source and the resistance.

Also, voltage dependent variable may include variable capacitors connected in series, and a control voltage may be applied to a node between the variable capacitors.

Also, the voltage controlled oscillator may be used in a phase locked loop circuit.

In another aspect of the present invention, a voltage controlled oscillator includes an LC resonance circuit provided between first and second output terminals and having two inductances connected in series and two capacitances connected in series, wherein the series-connected capacitances are connected in parallel to the series-connected inductances, a power source voltage is supplied to a node between the two inductances, and a control voltage is supplied to a node between the two capacitances to vary a capacitance; a transistor pair circuit connected in parallel with the LC resonance circuit between the first and second output terminals and having negative conductance to keep oscillation of the LC resonance circuit; a resistance having one end connected with the transistor pair circuit; and a current source connected between the other end of the resistance and a ground voltage.

Here, the transistor pair circuit may include a first transistor and a second transistor. The gate terminal of the first transistor may be connected with the first output terminal to output a first oscillation output signal, and the gate terminal of the second transistor may be connected with the second output terminal to output a second oscillation output signal. One terminal of each of the first and second transistors may be connected with the current source transistor through the resistance. The other terminal of the first transistor is connected with the second output terminal and the other terminal of the second transistor may be connected with the first output terminal.

Also, the current source may be a current mirror circuit comprising a current source transistor, and the first and second transistors and the current source transistor may be of a same conductive type.

Also, the voltage controlled oscillator may further include a capacitance connected to a node between the current source and the resistance.

In still another aspect of the present invention, a voltage controlled oscillator includes an LC resonance circuit provided between first and second output terminals and having two inductances connected in series and two capacitances connected in series, wherein the series-connected capacitances are connected in parallel to the series-connected inductances, and a control voltage is supplied to a node between the two capacitances to vary a capacitance; a first transistor pair circuit connected in parallel with the LC resonance circuit between the first and second output terminals and having negative conductance to keep oscillation of the LC resonance circuit; a second transistor pair circuit provided between the first and second output terminals on an opposite side to the first transistor pair circuit with respect to the LC resonance circuit, connected in parallel with the LC resonance circuit and having negative conductance to keep oscillation of the LC resonance circuit; a resistance having one end connected with the first transistor pair circuit; and a current source connected between the other end of the resistance and a first voltage. The second transistor pair circuit is connected to a second voltage.

Here, the first transistor pair circuit may include a first transistor and a second transistor. The gate terminal of the first transistor may be connected with the first output terminal to output a first oscillation output signal, and the gate terminal of the second transistor may be connected with the second output terminal to output a second oscillation output signal. One terminal of each of the first and second transistors may be connected with the current source transistor through the resistance, and the other terminal of the first transistor may be connected with the second output terminal and the other terminal of the second transistor may be connected with the first output terminal. The second transistor pair circuit may include third and fourth transistors. The gate terminal of the third transistor may be connected with the first output terminal, and the gate terminal of the fourth transistor may be connected with the second output terminal. One terminal of each of the third and fourth transistors may be a first voltage, and the other terminal of the third oscillation transistor may be connected with the second output terminal and the other terminal of the fourth oscillation transistor may be connected with the first output terminal.

Also, the current source may be a current mirror circuit comprising a current source transistor. The first and second transistors and the current source transistor are of a same conductive type, and are different in a conductive type from the third and fourth transistors.

Also, the voltage controlled oscillator may further include a capacitance connected to a node between the current source and the resistance.

### Brief Description of the Drawings

Fig. 1 is a circuit diagram showing a configuration of a voltage controlled oscillator of a first conventional example;
Fig. 2 is a diagram showing the oscillation output signals OUT 10 and OUT 20, voltage V10 at a node A10, and a circuit current I10 outputted from the current source 40 in the voltage controlled oscillator of the first conventional example;
Fig. 3 is a circuit diagram showing a circuit configuration of the voltage controlled oscillator according to a first embodiment of the present invention;
Fig. 4 shows the oscillation output signals OUT 1 and OUT 2, voltages V1 and V2 at the nodes A1 and B1, and a circuit current I1 outputted from the current source in the voltage controlled oscillator of the present invention;
Fig. 5 is a graph showing a simulation result of the relationship between consumed current and phase-noise level (offset frequency of 1 MHz);
Fig. 6 is a circuit diagram showing the circuit configuration of the voltage controlled oscillator according to a second embodiment of the present invention; and
Fig. 7 is a circuit diagram showing the circuit configuration of the voltage controlled oscillator according to a third embodiment of the present invention.

### Description of the Preferred Embodiments

Hereinafter, a voltage controlled oscillator of the present invention will be described in detail with reference to the attached drawings.

### [First Embodiment]

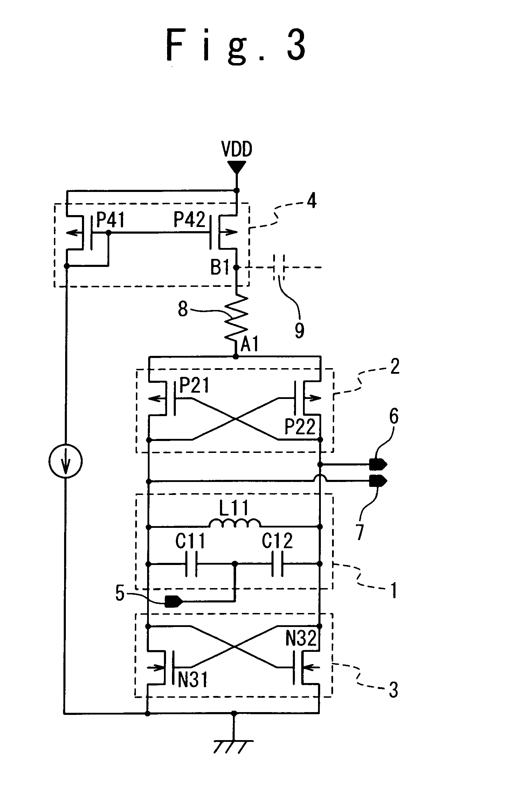

Fig. 3 is a circuit diagram showing a circuit configuration of the voltage controlled oscillator according to the first embodiment of the present invention. The voltage controlled oscillator in the first embodiment has an LC resonant circuit 1, a P-channel cross-coupled transistor pair 2, an N-channel cross-coupled transistor pair 3 and a constant current source 4. The P-channel cross-coupled transistor pair 2 and the N-channel cross-coupled transistor pair 3 are connected in parallel to the LC resonant circuit 1 through output terminals 6 and 7. The current source 4 is connected to the sources of the P-channel transistors P21 and P22 of the pair 2 (node A1) through a resistance 8. The LC resonant circuit 1 is provided with an inductor L11, and a variable capacitance connected in parallel to the inductor L11. Nodes between the inductor L11 and the variable capacitance are connected to the output terminals 6 and 7. The variable capacitance includes variable capacitors C11 and C12 connected in series to each other through a control voltage terminal 5. Capacitance of each of the variable capacitors C11 and C12 is controlled in accordance with a control voltage supplied to the control voltage terminal 5. A variable capacitor diode is used for the variable capacitor C11 or C12. The P-channel cross-coupled transistor pair 2 has the P-channel transistors P21 and P22, sources of which are connected to the resistance 8 through the node A1. The gate and drain of the P-channel transistor P21 are connected to the output terminals 6 and 7 respectively. The gate and drain of the P-channel transistor P22 are connected to the output terminals 7 and 6 respectively. The N-channel cross-coupled transistor pair 3 has N-channel transistors N31 and N32, sources of which are grounded. The gate and drain of the N-channel transistor N31 are connected to the output terminals 6 and 7 respectively. The gate and drain of the N-channel transistor N32 are connected to the output terminals 7 and 6 respectively. The current source 4 is a current mirror circuit having P-channel transistors P41 and P42, gates of which are connected to each other, and sources of which are connected in common to a power source voltage VDD. The drain and gate of the P-channel transistor P41 are connected in common to a constant current source, which supplies a constant current to the current mirror circuit. The drain of the P-channel transistor P42 is connected to the resistance 8 through a node B1. At this time, a low-pass filter is formed from the resistance 8 and a parasitic capacitance 9 in the node B1.

The LC resonant circuit 1 with the above configuration oscillates at a frequency (resonance frequency fo) that impedance is maximized, so that oscillation output signals OUT 1 and OUT 2 of the resonant frequency fo are outputted as a differential signal from the output terminals 6 and 7, respectively. At this time, the P-channel cross-coupled transistor pair 2 and the N-channel cross-coupled transistor pair 3 have negative conductance, so that the oscillation output signals can be outputted without attenuation. Additionally, a capacitance value of the variable capacitance in the LC resonant circuit changes in accordance with a control voltage supplied to the control voltage input terminal 5. That is to say, the voltage controlled oscillator operates as an oscillator in which the resonance frequency fo changes in accordance with the control voltage.

Fig. 4 shows the oscillation output signals OUT 1 and OUT 2, voltages V1 and V2 at the nodes A1 and B1, and a circuit current I1 outputted from the current source 4 in the voltage controlled oscillator of the present invention. As shown in Fig. 4, when the LC resonant circuit 1 of the present invention carries out an oscillation operation, even harmonics of the oscillation frequency of the oscillation output signals OUT 1 and OUT 2 are superimposed on the voltage V1 at the node A1 (in this case, a fourth harmonic is superimposed). However, owing to the low-pass filter of the resistance 8 and a parasitic capacitance connected to the node B1 as an output node of the current source 4, the even harmonic component is suppressed, and the voltage V2 at the node B1 is stabilized more. Consequently, oscillation of the circuit current I1 caused by the even harmonics is suppressed, and the phase-noise characteristic in the oscillation output signals OUT 1 and OUT 2 is improved.

Fig. 5 is a graph showing a simulation result of the relationship between consumed current and phase-noise level (offset frequency of 1 MHz). The simulation result shows the phase-noise and the consumed current in case of the voltage controlled oscillator of the first conventional example, and in case of the voltage controlled oscillator of the present invention when the resistance value of the resistance 8 is 20 Ω or 40 Ω. Considering manufacturing variations, current required to set the phase-noise to -100 [dBC/Hz] or below is 9 to 10 [mA] in the conventional example 1. However, the current is 6 to 7 [mA] and 5 to 6 [mA] when the resistance 8 of the present invention is 20 Ω and 40 Ω, respectively. Thus, the present invention can reduce the current required to suppress the phase-noise, compared with the first conventional example. As a result, it is possible to reduce consumed power in the voltage controlled oscillator by 30 to 40 percent, compared with the first conventional example.

Furthermore, the voltage controlled oscillator of the present invention connects the resistance 8 of approximately 20 to 40 Ω to the current source 4, and uses the parasitic capacitance 9 in the current source 4. Therefore, a required circuit area is less, compared with a case of connecting an inductor and so on.

Although the resistance of 20 Ω and 40 Ω is used as the resistance value of the resistance 8 in the first embodiment, an appropriate resistance value is used in accordance with the size of a power source voltage VDD, and characteristics of a transistor and an LC resonant circuit included in a circuit.

### [Second Embodiment]

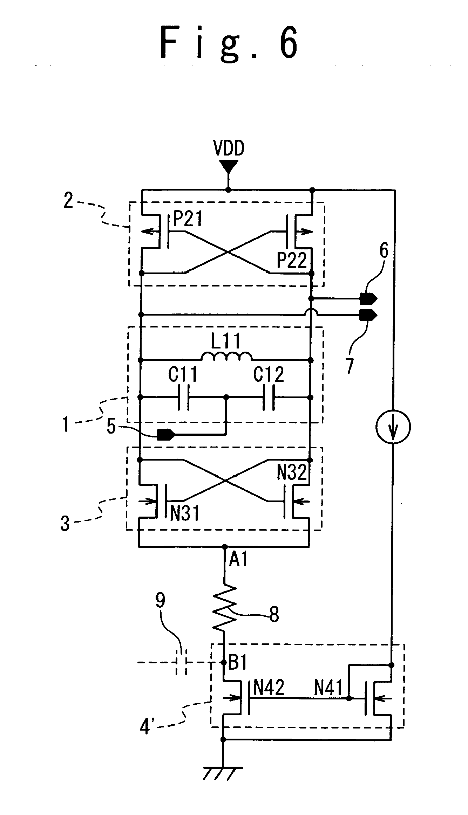

Fig. 6 is a circuit diagram showing the circuit configuration of the voltage controlled oscillator according to the second embodiment of the present invention. As shown in Fig. 6, the voltage controlled oscillator in the second embodiment is connected to a current source 4' using an N-channel transistor, instead of the current source 4 in the first embodiment.

The LC resonant circuit 1 in the second embodiment has the same configuration as the LC resonant circuit in the first embodiment. The P-channel cross-coupled transistor pair 2 has the P-channel transistors P21 and P22, sources of which are connected in common to the power source voltage VDD. The gate and drain of the P-channel transistor P21 are connected to output terminal 6 and 7, respectively. The gate and drain of the P-channel transistor P22 are connected to the output terminals 7 and 6, respectively. The N-channel cross-coupled transistor pair 3 has the N-channel transistors N31 and N32, sources of which are connected in common to the resistance 8. The gate and drain of the N-channel transistor N31 are connected to the output terminals 6 and 7, respectively. The gate and drain of the N-channel transistor N32 are connected to the output terminals 7 and 6, respectively. The current source 4' is a current mirror circuit having N-channel transistors N41 and N42, gates of which are connected to each other, and sources of which are grounded. The drain and gate of the N-channel transistor N41 are connected to a constant current source, which supplies a constant current to the current mirror circuit 4'. The drain of the N-channel transistor N42 is connected to the resistance 8 through a node B1. At this time, a low-pass filter is formed from the resistance 8 and a parasitic capacitance 9 at the node B1.

In the above configuration, the voltage controlled oscillator in the second embodiment reduces even harmonics caused through an oscillation operation by the low-pass filter of the resistance 8 and the parasitic capacitance 9, and improves the phase-noise characteristic, as in case of the first embodiment.

### [Third Embodiment]

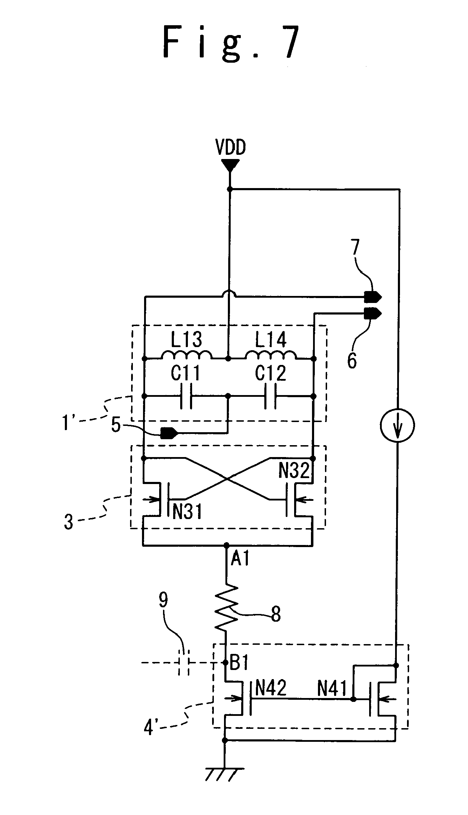

Fig. 7 is a circuit diagram showing the circuit configuration of the voltage controlled oscillator according to the third embodiment of the present invention. In the voltage controlled oscillator in the third embodiment, the P-channel cross-coupled transistor pair 2 in the first embodiment is omitted and the resistance 8 is inserted between a current source 4' and the sources of the N-channel cross-coupled transistor pair 3.

The LC resonant circuit 1' in the third embodiment has an inductor and a variable capacitance connected in parallel between the output terminals 6 and 7. The inductor is provided with inductors L13 and L14 connected in series to each other, and a connection point between the inductors L13 and L14 is connected to the power source voltage VDD. The variable capacitance is provided with variable capacitors C11 and C12 connected in series to each other through the control voltage input terminal 5. The N-channel cross-coupled transistor pair 3 has N-channel transistors N31 and N32, sources of which are connected to the resistance 8 through the node A1. The gate and drain of the N-channel transistor N31 are connected to the output terminals 6 and 7, respectively. The gate and drain of the N-channel transistor N32 are connected to the output terminals 7 and 6, respectively. The current source 4' is a current mirror circuit having N-channel transistors N41 and N42, gates of which are connected to each other, and sources of which are grounded. The drain and gate of the N-channel transistor N41 are connected to the constant current source, which supplies a constant current to the current mirror circuit 4'. The drain of the N-channel transistor N42 is connected to the resistance 8 through the node B1. At this time, a low-pass filter is formed from the resistance 8 and the parasitic capacitance 9 at the node B1.

In the above configuration, the voltage controlled oscillator in the third embodiment reduces even harmonics caused through an oscillation operation by the low-pass filter of the resistance 8 and the parasitic capacitance 9, and improves the phase-noise characteristic, as in the case of the first embodiment.

As explained above, the voltage controlled oscillator of the present invention can reduce even harmonics caused through an oscillation operation by the low-pass filter of the resistance 8 and the parasitic capacitance 9. Thus, it is possible to reduce phase-noise of the oscillation output signals OUT 1 and OUT 2. Consequently, the phase-noise characteristic can be improved without influence of manufacturing variations. In the above embodiments, the parasitic capacitance is used for the low-pass filter. However, a capacitance C may be used.

The embodiments of the present invention have been described in detail. The present invention is not limited to the specific configuration in the above embodiments. Various modifications without departing from the scope of the present invention are included in the present invention. For example, a MOS transistor is used in the embodiments as a transistor. However, a bipolar transistor may be used.

According to a voltage controlled oscillator of the present invention, it is possible to output an oscillation signal in which a phase-noise is reduced. Also, it is also possible to output an oscillation signal in which a phase-noise is reduced with low power consumption. Further, it is possible in a voltage controlled oscillator having a small circuit area, to output an oscillation signal in which a phase-noise is reduced.

## Claims

1. A voltage controlled oscillator comprising:
an LC resonance circuit (1) having an inductance and a voltage dependent variable capacitance connected in parallel between first and second output terminals;
a transistor pair circuit (2) connected in parallel with said LC resonance circuit between said first and second output terminals and having negative conductance to keep oscillation of said LC resonance circuit;
a resistance (8) having one end connected with said oscillation transistor pair circuit; and
a current source (4) connected with the other end of said resistance.

2. The voltage controlled oscillator according to claim 1, wherein said transistor pair circuit comprises a first transistor and a second transistor,
a gate terminal of said first transistor is connected with said first output terminal to output a first oscillation output signal, and a gate terminal of said second transistor is connected with said second output terminal to output a second oscillation output signal,
one terminal of each of said first and second transistors is connected with said current source transistor through said resistance, and
the other terminal of said first transistor is connected with said second output terminal and the other terminal of said second transistor is connected with said first output terminal.

3. The voltage controlled oscillator according to claim 1 or 2, wherein said inductance comprises two inductors connected in series,
a node between said two inductors is connected to a power supply voltage, and
said current source is connected to a ground voltage.

4. The voltage controlled oscillator according to claim 2 or 3, wherein said current source comprises a current source transistor, and
said first and second transistors and said current source transistor are of a same conductive type.

5. The voltage controlled oscillator according to claim 2, further comprising:
another transistor pair circuit (3) connected in parallel with said LC resonance circuit between said first and second output terminals on an opposite side to said transistor pair circuit with respect of said LC resonance circuit and having negative conductance to keep oscillation of said LC resonance circuit.

6. The voltage controlled oscillator according to claim 5, wherein said another transistor pair circuit comprises third and fourth transistors,
a gate terminal of said third transistor is connected with said first output terminal, and a gate terminal of said fourth transistor is connected with said second output terminal,
one terminal of each of said third and fourth transistors is a first voltage, and
the other terminal of said third oscillation transistor is connected with said second output terminal and the other terminal of said fourth oscillation transistor is connected with said first output terminal, and
said current source is connected with a second voltage.

7. The voltage controlled oscillator according to claim 6, wherein one of said first voltage and said second voltage is a power source voltage and the other is a ground voltage.

8. The voltage controlled oscillator according to claim 6 or 7, wherein said current source comprises a current source transistor,
said first and second transistors and said current source transistor are of a same conductive type, and
the conductive type of said first and second transistors is different from that of said third and fourth transistors.

9. The voltage controlled oscillator according to any of claims 1 to 3, and 5 to 7, wherein said current source is a current mirror circuit including a current source transistor.

10. The voltage controlled oscillator according to any of claims 1 to 9, further comprising:
a capacitance connected to a node between said current source and said resistance.

11. The voltage controlled oscillator according to any of claims 1 to 10, wherein said voltage dependent variable comprises variable capacitors connected in series, and
a control voltage is applied to a node between said variable capacitors.

12. The voltage controlled oscillator according to any of claims 1 to 11, which is used in a phase locked loop circuit.
